# EUROPEAN PATENT APPLICATION

(11) **EP 1 734 396 A1**
(43) Date of publication of application: **20.12.2006**
(21) Application number: 06253164.5
(22) Date of filing: 19.06.2006
(51) Int. Cl.: G02B 27/00, H04B 10/00, G03B 21/00, H01S 5/40

(54) **Multiple head laser projector and method**

(30) Priority: 17.06.2005 US 691970 P
(71) Applicant: Virtek Vision International, Inc., Waterloo, ON N2V 2K1 (CA)
(72) Inventor: Rueb, Kurt D., Kitchener, Ontario N2N 2C1 (CA); Matic-Vujovic, Marina, Kitchener, Ontario N2B 2Y2 (NA); Komarnycky, O. Nicholas, Kitchener, Ontario N2P 2A8 (CA)
(74) Representative: Brunner, Michael John

(57) **Abstract**

A multiple laser head projector includes a sensor that senses the presence or absence of a laser beam from a first of the laser heads and signals a switching device to switch to a second laser head when a laser beam is not detected by the sensor from the first laser head. Thus, the multiple laser head projector may be utilized to provide continuous operation of the multiple head laser projector when one of the lasers fails. The multiple head laser projector may also be utilized for diagnostic testing of the laser heads, such as during start-up. Further, the multiple head laser projector may be utilized to signal the power output of the laser heads and thus the expected remaining life of the laser heads.

## Description

### Field of the Invention

The present invention generally relates to laser projectors and more specifically to a multiple head laser projector and method that may be utilized for continuous operation of a laser projector upon failure of one of the laser heads and for diagnosis.

### Background to the Invention

Laser projectors are now used for various industrial applications including, for example, alignment of components prior to assembly, such as truss assemblies, ply and aircraft manufacture, and/or the like, and for placement of components and decals on aircraft. A conventional laser projector or laser projection system includes a laser head with generates a laser beam, a collimator, galvanometers and angularly related scanning mirrors which receive the laser beam from the collimator and deflect the laser beam onto a surface, such as a work surface. A conventional laser projector further includes a computer having algorithms for control of the laser image or template to be projected, and various power and electronic components. Co-pending U.S. Patent Application Serial No. 10/961,599, filed October 8, 2004, discloses an improved temperature control for a laser projector, but also discloses the optical and power components of a laser projection system.

As will be understood by those skilled in this art, the laser head, which generates a laser beam, has a limited life and must be periodically replaced. However, in an industrial application, when the laser head fails, the laser projection apparatus must be shut down, typically stopping production, and replaced.

Thus, there has been a long felt need for a laser projector which will continue operation when the laser head fails, permitting replacement when the laser projector is not in use. Further, the prior art does not disclose a laser projector permitting periodic tests or diagnosis of the laser head, such as during start-up.

### Summary of the Invention

The multiple head laser projector and method of the present invention solves the aforementioned problems, permitting continuous operation of the laser projector when the laser head fails and providing for an automatic diagnostic or test method.

In accordance with the general teachings of the present invention, the multiple head laser projector includes at least two laser heads aligned to generate a laser beam, a sensor receiving a laser from each of the laser heads and a switching device connected to the sensor switching from one of the laser heads to the other of the laser heads. In this aspect, the laser beams from two laser heads are aligned by a beam splitter and the laser beams from the laser projectors are directed to the sensor by a beam splitter. However, other methods may also be used to align the laser beams from the laser head in the same laser path and direct the laser beams to the sensor, including the use of a flap mirror or a rotating mirror, for example.

In accordance with one aspect of the present invention, the multiple laser head projector includes a sensor that senses the presence or absence of a laser beam from a first of the laser heads and signals the switching device to switch to a second laser head when a laser beam is not detected by the sensor from the first laser head. Thus, the multiple laser head projector of the present invention may be utilized to provide continuous operation of the multiple head laser projector when one of the lasers fails. The method of continuous operation thus includes aligning the laser beams from at least two laser heads in a common path, and locating a sensor to receive a laser beam from the laser heads, wherein the sensor senses the presence or absence of a laser beam from the first laser head and the sensor signals a switching device switching from the first laser head when the sensor detects the absence of a laser beam from the first laser head to a second laser head to maintain continuous operation of the laser projector.

In accordance with another aspect of the present invention, the multiple head laser projector may also be utilized for diagnostic testing of the laser heads, such as during start-up. Further, the multiple head laser projector of the present invention may be utilized to signal the power output of the laser heads and thus the expected remaining life of the laser heads. In this aspect, the multiple head laser projector includes a test sequence, wherein the switching device switches from one of the laser heads to the other of the laser heads and the sensor generates a signal proportional to the power output of the laser beams detected and sends a signal to the computer interface, for example, of the expected remaining life of the laser heads. In an alternative aspect of the test sequence, the switching device switches from one of the laser heads to the other of the laser heads and the sensor detects the presence or absence of a laser beam from each of the laser heads and signals an absence of a laser beam from either of the laser heads and switches to the other laser head when a laser beam is not detected. The test method of the present invention thus includes aligning a laser beam from at least two laser heads in a common path, locating a sensor to receive a laser beam from each of the laser heads, and switching the laser beams directed to the sensor from one of the laser heads to the other of the laser heads and the sensor generates a signal of a condition of the laser heads, such as the absence of a laser beam from one of the laser heads or a signal proportional to the power output of the laser beam detected.

In accordance with still another aspect of the present invention, there is provided a method and apparatus for replacing a laser module in a laser projector without having to power the laser projector down. Presently, laser modules are periodically replaced by first powering down or disconnecting the power supply, then reaching inside of the projector through an opening provided for service, disconnecting the connector to the laser module, quick releasing and taking out of the old module, dropping the new one in place, securing it and connecting the connector to the board. The laser projector may then be powered up. As used herein, the term "laser module" includes the laser source or laser head and typically includes a tuned driver board which drives the laser head, including a power control. However, the term laser module as used herein may be limited to the laser head with appropriate connectors. As will be understood by those skilled in this art, this method requires interruption of the use of the laser projector, powering down the projector, waiting an appropriate time and then removing and replacing the laser module as described. Then, the laser projector may be reconnected to the power source. The design of the laser module, associated driver circuit, type of the connector used and connecting apparatus of the present invention provides a safe and efficient method permitting an operator to "hot-swap" a laser module and its electronics in and out of the laser projector without powering down the laser projector.

In accordance with a first embodiment of the present invention, a multiple head laser projector is provided, comprising: (1) at least two laser heads aligned to generate a laser beam; and (2) a switching device selectively operable to switch from one of the laser heads to another of the laser heads, such that either of the laser heads may be utilized to direct a laser beam in a laser path.

In accordance with a first alternative embodiment of the present invention, a test method for a multiple head laser projector is provided, comprising: (1) aligning a laser beam from at least two laser heads in a common path; and (2) switching the laser beams from one of the laser heads to another of the laser heads, wherein a signal is generated of a condition of the laser heads.

In accordance with a second alternative embodiment of the present invention, a method of continuous operation of a multi-head laser projector is provided, comprising: (1) aligning the laser beams from at least two laser heads in a common path; and (2) signaling a switching device to switch from one of the laser heads to another of the laser heads to maintain a continuous operation of the multi-head laser projector.

Further areas of applicability of the present invention will become apparent from the detailed description provided hereinafter. It should be understood that the detailed description and specific examples, while indicating the various embodiments of the invention, are intended for purposed of illustration only and are not intended to limit the scope of the invention.

### Brief Description of the Drawings

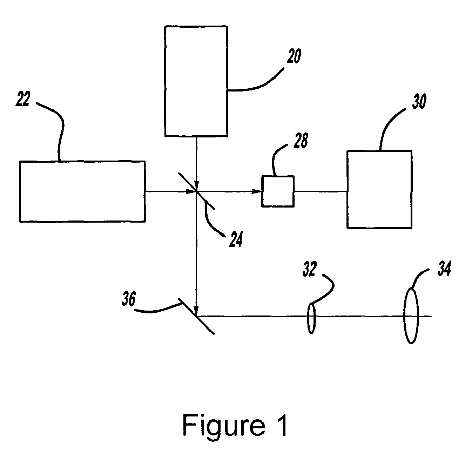

Figure 1 is a schematic illustration of one embodiment of a multiple head laser projector of the present invention.

### Detailed Description of the Invention

The following description of the various embodiment(s) is merely exemplary in nature and is in no way intended to limit the invention, or uses.

The Figure illustrates one embodiment of a multiple head laser projector of the present invention, including at least two laser heads 20 and 22, each projecting a laser beam, wherein the laser beams are coaxially aligned in the same or a common path by a beam splitter 24 as shown at 26. The laser beams from the laser heads 20 and 22 may further be directed to an optional sensor 28 connected to the control electronics 30 of the laser projector which controls the operation of the laser heads 20 and 22. As set forth above and discussed further herein below, the sensor 28 detects a laser beam received through the beam splitter 24 and generates a signal to the control electronics 30.

In accordance with an alternative embodiment of the present invention, the optional sensor can be substituted for control systems, such as on-board control systems as opposed to external sensors, that can detect and sense the performance parameters of the individual laser heads, such that the control systems can automatically switch between various laser heads, or alternatively, prompt or alert an operator to a potential or actual performance problem with a particular laser head. In this manner, the operator can manually change from one laser head that may be experiencing problems to another laser head that is functioning normally. Furthermore, the present invention can provide that the operator can manually switch operation between the various laser heads, without any input from the previously described sensors and/or control systems.

In one embodiment of the present invention, the multiple head laser projector includes a signal generated by the sensor 28 that is proportional to the power of the laser beam detected. That is, the control electronics 30 is operated to alternatively project a laser beam from the laser heads 20 and 22 which are directed to the sensor 28 by the beam splitter 24 which is proportional to the power of the laser beam detected from the laser heads 20 and 22 which is an indication of the remaining life of the laser heads. This information can then be displayed on a computer interface or computer screen (not shown) advising the laser projector operator of the remaining life of the laser heads 20 and 22.

As set forth above, this method of operation may be utilized as a diagnostic method or test of the laser heads 20 and 22. Alternatively, the sensor 28 may be utilized to detect the presence or absence of a laser beam from one of the laser heads 20 and 22 and the control electronics 30 is utilized as a switching device to switch or automatically switch to the laser head 20 or 22 from which the sensor 28 receives a laser beam. That is, the multiple head laser projector of the present invention may be utilized to automatically provide a back-up when one of the laser heads 20 or 22 fails or for diagnostics.

The multiple head laser projector of the present invention may be utilized in a conventional laser projector including a collimator 32 and a rotating mirror 34 which projects a laser beam: from one of the laser heads 20 or 22 onto a work surface (not shown). In the disclosed embodiment of the multiple head laser projector of the present invention, a second beam splitter 36 directs the laser beam from one of the laser heads 20 or 22 to the collimator 32.

As will be understood, however, the multiple head laser projector of the present invention may be utilized with any conventional laser projector and thus the present invention is not limited to the disclosed embodiment. Further, the laser beams from the laser heads 20 and 22 may be coaxially aligned in a common path by any suitable methods including, for example, using a flap mirror or a rotating mirror, and thus the present invention is not limited to the use of a beam splitter to coaxially align the laser beams from the laser heads 20 and 22. Further, as described above, the multiple head laser projector of the present invention may be utilized with more than two laser heads wherein the laser beams from the plurality of laser heads are coaxially aligned in a common path as described above.

The multiple head laser projector of the present invention may be utilized as a backup to assure continuous operation of the multiple head laser projector when one of the lasers fails. For example, the multiple head laser projector may be operated with laser head 20 during normal operation. The sensor 28 then continuously senses or detects the presence or absence of a laser beam from the laser head 20. However, when the laser head 20 eventually fails to project a laser beam, the sensor 28 senses the absence of a laser beam from the laser head 20 and the sensor 28 then signals the control electronics 30 which operates as a switching device, automatically switching to the second laser head 22, assuring continuous operation of the laser projector. Thus, the second laser head 22 serves as a back-up for the first laser head 20. Obviously, however, the roles of the laser heads 20 and 22 can be reversed.

The multiple head laser projector of the present invention may also be utilized for diagnosis of the status of the laser heads 20 and 22 in a test or diagnostic procedures. In this application, the switching device of the control electronics 30 may be utilized to switch between the laser heads 20 and 22 in a test procedure, such as during start-up. In this procedure, the sensor 28 may be utilized to sense the presence or absence of a laser beam from the laser heads 20 or 22 during the test procedure. If the sensor detects the absence of a laser beam from one of the laser heads 20 and 22, the control electronics may be utilized to automatically switch to the laser head which is projecting a laser beam, and this information is displayed on the computer interface, permitting the operator to replace the defective laser head at any convenient time, such as when the laser projector is not being used.

Alternatively, as described above, the sensor may be utilized to generate a signal proportional to the power of the laser beam detected which, as described above, is also proportional to the remaining (or expected remaining) life of the laser heads 20 and 22. This information may also be displayed on the computer interface or computer screen and thus provides information to the operator of the laser projector of the remaining life of the laser heads 20 and 22. Thus, the test method of the present invention may be utilized in combination with the backup system described above.

As previously noted, the design of the laser module, associated driver circuit, type of the connector used and connecting apparatus of the present invention provides a safe and efficient method permitting an operator to "hot-swap" a laser module and its electronics in and out of the laser projector without powering down the laser projector. The laser driver circuit and mounting design allows for the laser module and housing to be at ground potential when powered, same potential as laser projector chassis ground.

In accordance with one aspect of the present invention, the connector used on the laser driver board is chosen to be a sequential type and the connecting scheme is such that it connects the electrical ground first, then power supply and control signal in second level, or in second and third level. The connector may be an off-the-shelf product type generally known as "make-first/break-last" connectors having recessed pins or contacts designed to establish connection in the sequence described above with the ground contacts on longer pins first and break last. The laser module driving circuit has a simple soft-start circuit to provide contact de-bouncing and protect laser and electronics from damage and without having to power down the laser projector. As will be understood, however, other types of quick connect connectors may also be used provided the connector first connects the electrical ground first, followed by the power supply and control signal. For example, a four prong connector including two projecting contacts to electrical ground or ground potential and two recessed prongs or contacts to the laser power source and control circuit may be used, but the number of prongs or contacts will depend upon the application.

The method of replacing a laser module in a laser projector without powering down the laser projector of this invention thus includes removing the defective laser module from the laser projector, then connecting a new laser module in the laser projector by first connecting the electrical ground, then connecting the power supply and control signal. In accordance with another aspect of the present invention, the laser projector includes a connector having projecting and recessed contacts, wherein the method of the present invention includes connecting the electrical ground in the projecting contacts and then connecting the power supply and control signal in the recessed contacts.

As set forth above, the multiple head laser projector of the present invention is not limited to the multiple head laser projector shown in the Figure. The multiple head laser projector of the present invention may be utilized with any conventional laser projector to provide backup for the laser heads 20 and 22 or utilized in a test method described above. The multiple head laser projector of the present invention may include more than two laser heads and the laser beams from the laser heads 20 and 22 may be coaxially aligned in a common or the same laser path by any suitable means as described above.

The description of the invention is merely exemplary in nature and, thus, variations that do not depart from the invention are intended to be within the scope of the invention. Such variations are not to be regarded as a departure from the scope of the invention.

## Claims

1. A multiple head laser projector, comprising:
at least two laser heads aligned to generate a laser beam; and
a switching device selectively operable to switch from one of said laser heads to another of said laser heads, such that either of said laser heads may be utilized to direct a laser beam in a laser path.

2. The invention according to claim 1, further comprising a sensor receiving the laser beam from said laser heads, wherein said switching device is operably associated with said sensor.

3. The invention according to claim 2, wherein said sensor senses the presence or absence of a laser beam from one of said laser heads and signals said switching device to switch to another of said laser heads when a laser beam is not detected by said sensor from said one of said laser heads.

4. The invention according to claim 3, wherein said multiple head laser projector includes a test sequence, wherein said switching device switches from said one of said laser heads to said other of said laser heads, and said sensor generates a signal proportional to the power of the laser beam detected.

5. The invention according to claim 4, wherein said test sequence includes said sensor signaling an absence of a laser beam from one of said laser heads and switching to said other of said laser heads when a laser beam is not detected from said one of said laser heads.

6. The invention according to claim 4, wherein said sensor sends a signal of the remaining life of said laser head.

7. The invention according to any preceding claim, wherein said laser beams of said laser heads are aligned in the same laser path by a beam splitter.

8. The invention according to any preceding claim, wherein said multiple head laser projector includes a collimator and said laser path is directed through said collimator.

9. The invention according to any preceding claim, wherein either of said laser heads can be in-field replaced without the need for either alignment or powering down of the laser projector.

10. A test method for a multiple head laser projector, comprising:
aligning a laser beam from at least two laser heads in a common path; and
switching said laser beams from one of said laser heads to another of said laser heads;
wherein a signal is generated of a condition of said laser heads.

11. The invention according to claim 10, further comprising locating a sensor receiving the laser beam from said laser heads, wherein said sensor is operably associated with said switching device.

12. The invention according to claim 10, further comprising generating a signal proportional to the power of said laser beams.

13. The invention according to claim 11, further comprising generating a signal when a laser beam from one of said laser heads is not detected by the sensor.

14. The invention according to claim 13, further comprising switching to another of said laser heads when a laser beam from one of said laser heads is not detected.

15. The invention according to any of claims 10 to 14, wherein either of said laser heads can be in-field replaced without the need for either alignment or powering down of the laser projector.

16. A method of continuous operation of a multi-head laser projector, comprising:
aligning the laser beams from at least two laser heads in a common path; and
signaling a switching device to switch from said one of said laser heads to another of said laser heads to maintain a continuous operation of said multi-head laser projector.

17. The invention according to claim 16, further comprising locating a sensor to receive a laser beam from said laser heads, wherein said sensor senses the presence or absence of a laser beam from one of said laser heads.

18. The invention according to claim 17, further comprising directing the laser beams from the laser heads to the sensor with a beam splitter.

19. The invention according to any of claims 16 to 18, further comprising aligning the laser beams from the laser heads with a beam splitter.

20. The invention according to any of claims 16 to 19, further comprising directing one of said laser beams through a collimator.

21. The invention according to any of claims 16 to 20, wherein either of said laser heads can be in-field replaced without the need for either alignment or powering down of the laser projector.
